# EUROPEAN PATENT APPLICATION

(11) **EP 1 684 337 A1**
(43) Date of publication of application: **26.07.2006**
(21) Application number: 04793047.4
(22) Date of filing: 27.10.2004
(51) Int. Cl.: H01L 21/304, C11D 7/26, C11D 7/32

(54) **CLEANING COMPOSITION FOR SEMICONDUCTOR CONTAINING UNSATURATED DICARBOXYLIC ACID AND ETHYLENE UREA AND CLEANING METHOD**

(30) Priority: 30.10.2003 US 695773
(71) Applicant: Nissan Chemical Industries, Ltd., Chiyoda-ku, Tokyo 101-0054 (JP)
(72) Inventor: MIYAZAWA, Tomoe, Nissan Chem. Ind., Ltd., Funabashi-shi Chiba, 2748507 (JP); FUJITA, Yoichiro, Nissan Chemical Industries, Ltd., Funabashi-shi Chiba, 2748507 (JP); KOBAYASHI, Ichiro, Nissan Chemical Industries, Ltd, Tokyo, 1010054 (JP)
(74) Representative: HOFFMANN EITLE
(86) International application number: PCT/JP2004/015935
(87) International publication number: WO 2005/043610

(57) **Abstract**

A semiconductor wafer cleaning formulation comprising an unsaturated dicarboxylic acid and ethylene urea, and a cleaning method are provided. The formulation comprises an unsaturated dicarboxylic acid and ethylene urea as essential components, and is used for removing residues in semiconductor fabrication. As the unsaturated dicarboxylic acid, maleic acid is particularly preferable. The preferred formulation comprises an unsaturated dicarboxylic acid, ethylene urea, at least one organic carboxylic acid except unsaturated dicarboxylic acid, at least one basic compound except ethylene urea and water. The formulation can optionally comprise at least one selected from the group consisting of an organic solvent, a chelating agent, a surfactant, and phosphonic acid and/or phosphinic acid.

## Description

### Background of Invention

The present invention relates generally to a chemical formulation used in semiconductor wafer fabrication and particularly to a chemical formulation that is utilized to remove residue from wafers following plasma ashing of a photoresist. More specifically, the present invention relates to a chemical formulation for removal of residue from semiconductor wafers containing chemically delicate copper interconnect and low-k or ultra low-k interlayer insulator layers.

### Background Art

As semiconductor wafer designs recently become smaller, semiconductor wafers are being developed by using copper interconnect material for reducing wiring resistance and by using low-k interlayer insulator layers (low-k film) or ultra low-k interlayer insulator layers (ultra low-k film) having a k-value of 3.0 or less for reducing interconnect capacity. Representative wafers include single damascene or dual damascene wafers.

Pattern formation by use of interconnect material, interlayer insulator layer material or the like is mainly carried out by dry etching by utilizing a photoresist as a mask and then plasma ashing for removal of the photoresist.

The prior art tells the utilization of various chemical formulations to remove residue and clean wafers following a plasma ashing process. Most of these prior art chemical formulations are based on alkaline amines (for example, see Patent Document 1) and fluorine compounds (for example, see Patent Document 2). Still other chemical formulations are based on organic carboxylic acids (for example, see Patent Document 3).
Patent Document 1: US patent No. 5334332
Patent Document 2: EP patent No. 662705
Patent Document 3: US publication No. 2003/0143495 A1

### Disclosure of the Invention

### Problem to be solved by the Invention

These various prior art chemical formulations have drawbacks that often include unwanted removal of wiring metal such as copper or low-k and ultra low-k insulator layers. There is therefore a need for chemical formulations that effectively remove residue following a resist ashing process and do not affect on wiring metal and low-k and ultra low-k interlayer insulator layers.

### Means for solving the Problem

The present invention relates generally to a chemical formulation used in semiconductor wafer fabrication and particularly to a chemical formulation that is utilized to remove residue from wafers following a plasma ashing process of photoresist. Namely, the present invention relates to the following invention [1] to [12]:
[1] A semiconductor wafer cleaning formulation for use in semiconductor fabrication comprising (a) an unsaturated dicarboxylic acid, and (b) ethylene urea (2-imidazolidone);
[2] The cleaning formulation as described in [1], further comprising (c) at least one organic carboxylic acid except unsaturated dicarboxylic acid, (d) at least one basic compound except ethylene urea, and (e) water;
[3] The cleaning formulation as described in [2], further comprising at least one selected from the group consisting of (f) an organic solvent, (g) a chelating agent, (h) a surfactant, and (i) phosphonic acid and/or phosphinic acid;
[4] The cleaning formulation as described in [1]-[3], comprising each component (a) to (i) in the following amount shown in percentage by weight based on total weight of the formulation:

| | |
|---|---|
| (a) an unsaturated dicarboxylic acid | 1-9% by weight |
| (b) ethylene urea | 1-20% by weight |
| (c) at least one organic carboxylic acid except unsaturated dicarboxylic acid | 1-20%by weight |
| (d) at least one basic compound except ethylene urea | 0.1-50% by weight |
| (e) water | 2-90% by weight |
| (f) an organic solvent | 1-20 by weight |
| (g) a chelating agent | 0.01-5% by weight |
| (h) a surfactant | 0.01-0.2% by weight |
| (i) phosphonic acid and/or phosphinic acid | 0.5-5% by weight; |

[5] A method for cleaning a semiconductor wafer comprising cleaning the wafer by using a semiconductor wafer cleaning formulation comprising (a) an unsaturated dicarboxylic acid, and (b) ethylene urea, in semiconductor fabrication;
[6] The method for cleaning a semiconductor wafer described in [5], wherein the semiconductor wafer cleaning formulation further comprising (c) at least one organic carboxylic acid except unsaturated dicarboxylic acid, (d) at least one basic compound except ethylene urea, and (e) water is used;
[7] The method for cleaning a semiconductor wafer described in [6], wherein the semiconductor wafer cleaning formulation further comprising at least one selected from the group consisting of (f) an organic solvent, (g) a chelating agent, (h) a surfactant, and (i) phosphonic acid and/or phosphinic acid is used;
[8] The method for cleaning a semiconductor wafer described in [5]-[7], wherein the semiconductor wafer cleaning formulation comprising each component (a) to (i) in the following amount shown in percentage by weight based on total weight of the formulation is used:

| | |
|---|---|
| (a) an unsaturated dicarboxylic acid | 1-9% by weight |
| (b) ethylene urea | 1-20% by weight |
| (c) at least one organic carboxylic acid except unsaturated dicarboxylic acid | 1-20%by weight |
| (d) at least one basic compound except ethylene urea | 0.1-50% by weight |
| (e) water | 2-90% by weight |
| (f) an organic solvent | 1-20 by weight |
| (g) a chelating agent | 0.01-5% by weight |
| (h) a surfactant | 0.01-0.2% by weight |
| (i) phosphonic acid and/or phosphinic acid | 0.5-5% by weight; |

[9] A method for cleaning a semiconductor wafer comprising cleaning the wafer by using a semiconductor wafer cleaning formulation comprising (a) an unsaturated dicarboxylic acid, and (b) ethylene urea, in (1) a cleaning process after making via hole, (2) a cleaning process after making trench, (3) a cleaning process after punching of etch stopper layer, or (4) a cleaning process after CMP (chemical mechanical polishing) among semiconductor fabrication;
[10] The method for cleaning a semiconductor wafer described in [9], wherein the semiconductor wafer cleaning formulation further comprising (c) at least one organic carboxylic acid except unsaturated dicarboxylic acid, (d) at least one basic compound except ethylene urea, and (e) water is used;
[11] The method for cleaning a semiconductor wafer described in [9], wherein the semiconductor wafer cleaning formulation further comprising at least one selected from the group consisting of (f) an organic solvent, (g) a chelating agent, (h) a surfactant, and (i) phosphonic acid and/or phosphinic acid is used;
[12] The method for cleaning a semiconductor wafer described in [9]-[11], wherein the semiconductor wafer cleaning formulation comprising each component (a) to (i) in the following amount shown in percentage by weight based on total weight of the formulation is used:

| | |
|---|---|
| (a) an unsaturated dicarboxylic acid | 1-9% by weight |
| (b) ethylene urea | 1-20% by weight |
| (c) at least one organic carboxylic acid except unsaturated dicarboxylic acid | 1-20%by weight |
| (d) at least one basic compound except ethylene urea | 0.1-50% by weight |
| (e) water | 2-90% by weight |
| (f) an organic solvent | 1-20 by weight |
| (g) a chelating agent | 0.01-5% by weight |
| (h) a surfactant | 0.01-0.2% by weight |
| (i) phosphonic acid and/or phosphinic acid | 0.5-5% by weight. |

The chemical formulation of the present invention is effective for removing residues from wafers formed in semiconductor wafer fabrication, particularly for removing all residue from wafers following a plasma ashing process. Especially, these formulations are effective in the cleaning of dual damascene wafer. Fabrication processes of dual damascene structure wafer are as follows: (i) after depositions of interlayer insulator layer, etch stopper layer and photoresist, and son on, a via hole is constructed by dry etching and plasma ashing; (ii) filling a photoresist or other material in the via hole, and trench structure is constructed by the same process as above; (iii) etch stopper layer is removed by punching; and (iv) after filling copper into the via hole and trench together, overfilled copper is polished by CMP (chemical mechanical polishing). After each of (i) to (iv) processes, cleaning processes are carried out. The formulation of the present invention is effective in all of the cleaning processes.

That is, it is an advantage of the formulation of the present invention that it effectively removes residue following a plasma ashing process.

It is another advantage of the formulation that it can effectively remove especially etch stopper layer punching residues. Generally, the etch stopper layer punching residues are often difficult to be completely removed without any damage on copper and low-k and ultra low-k interlayer insulator layers. But the formulation can remove such etch residues without any damage thereon.

It is a further advantage of the formulation that it effectively removes metal oxide like copper oxide or metal halides like copper fluoride following plasma ashing.

It is a further advantage of the formulation that it effectively removes metal oxide like copper oxide remaining after CMP (chemical mechanical polishing).

It is yet another advantage of the formulation that it provides residue removal performance with less corrosivity on copper than conventional acidic cleaning solutions.

It is yet a further advantage of the formulation that it provides residue removal performance with less corrosivity on low-k and ultra low-k interlayer insulator layers than conventional amine-based and ammonium fluoride-based cleaning solutions.

It is yet another advantage of the formulation that it provides residue removal performance with lower temperature than conventional amine-based and ammonium fluoride-based cleaning solutions.

It is yet a further advantage of the formulation that it provides residue removal performance with shorter treatment time than conventional amine-based and ammonium fluoride-based chemicals.

These and other features and advantages of the formulation will become understood to those of ordinary skill in the art upon review of the following detailed description of the preferred embodiments.

### Best Mode for carrying out the Invention

The present invention relates to a chemical formulation that is suitable for removing residues originating from dry etching and plasma ashing, or the like in semiconductor wafer fabrication. The formulation comprises (a) an unsaturated dicarboxylic acid, and (b) ethylene urea, as essential components. Among (a) the unsaturated dicarboxylic acids, maleic acid is particularly preferable. The composition preferably comprises (a) an unsaturated dicarboxylic acid, (b) ethylene urea, (c) at least one organic carboxylic acid except unsaturated dicarboxylic acid, (d) at least one basic compound except ethylene urea, and (e) water. In addition, the preferable composition may contain at least one selected from the group consisting of (f) an organic solvent, (g) a chelating agent, (h) a surfactant, and (i) phosphonic acid and/or phosphinic acid.

The amount shown in percentage by weight (based on total weight of the formulation) of each component of the formulation is suitably determined depending on the object to be removed, but the following amount is preferable:

| | |
|---|---|
| (a) an unsaturated dicarboxylic acid | 1-9% by weight |
| (b) ethylene urea | 1-20% by weight |
| (c) at least one organic carboxylic acid except unsaturated dicarboxylic acid | 1-20%by weight |
| (d) at least one basic compound except ethylene urea | 0.1-50% by weight |
| (e) water | 2-90% by weight |
| (f) an organic solvent | 1-20 by weight |
| (g) a chelating agent | 0.01-5% by weight |
| (h) a surfactant | 0.01-0.2% by weight |
| (i) phosphonic acid and/or phosphinic acid | 0.5-5% by weight |

Preferable unsaturated dicarboxylic acids (a) are
(a-1) maleic acid, and
(a-2) citraconic acid, particularly preferable unsaturated dicarboxylic acids (a) is
(a-1) maleic acid.

Preferable organic carboxylic acids (c) are
(c-1) formic acid (FA),
(c-2) acetic acid (AA), and
(c-3) propionic acid (PA).

Preferable basic compounds (d) are
(d-1) hydroxyethylpiperazine (HEP),
(d-2) hydroxypropylpiperazine (HPP),
(d-3) aminoethylpiperazine (AEP),
(d-4) aminopropylpiperazine (APP),
(d-5) hydroxyethylmorpholine (HEM),
(d-6 hydroxypropylmorpholine (HPM),
(d-7) aminoethylmorpholine (AEM),
(d-8) aminopropylmorpholine (APM),
(d-9) triethanolamine (TEA),
(d-10) pentamethyldiethylenetriamine (PMDETA),
(d-11) dimethylaminoethoxyethanol (DMAEE),
(d-12) aminoethoxyethanol (AEE),
(d-13) trimethylaminoethylethanolamine (TMAEEA),
(d-14) trimethylaminopropylethanolamine (TMAPEA),
(d-15) N-(2-cyanoethyl)ethylenediamine (CEEDA),
(d-16) N-(2-cyanopropyl)ethylenediamine (CPEDA). and
(d-17) ammonia (NH₃).

Preferable organic solvents (f) are
(f-1) 1,4-butanediol (1,4-BD),
(f-2) 1,3-butanediol (1,3-BD),
(f-3) ethylene glycol (EG),
(f-4) propylene glycol (PG),
(f-5) N-methylpyrrolidone(NMP),
(f-6) γ-butyrolactone (GBL),
(f-7) propylene glycol monomethylether (PGME), and
(f-8) propylene glycol monomethylether acetate (PGMEA).

Preferable chelating agents (g) are
(g-1) ascorbic acid,
(g-2) gluconic acid,
(g-3) mannitol,
(g-4) sorbitol, and
(g-5) boric acid.

Preferable surfactants (h) are
(h-1) C₁₋₁₀alkyl glucosides.

Each component in the formulation included in the present invention can be arbitrarily combined. Combinations of each component include for example those shown in the following table. In the meantime, the table is shown for purposes of illustration, and the present invention is not limited to these combinations.

| (a) | (b) | (c) | (d) | (e) |
|---|---|---|---|---|
| (a-1) | (b) | (c-1) | (d-1) | (e) |
| (a-1) | (b) | (c-1) | (d-2) | (e) |
| (a-1) | (b) | (c-1) | (d-3) | (e) |
| (a-1) | (b) | (c-1) | (d-4) | (e) |
| (a-1) | (b) | (c-1) | (d-5) | (e) |
| (a-1) | (b) | (c-1) | (d-6) | (e) |
| (a-1) | (b) | (c-1) | (d-7) | (e) |
| (a-1) | (b) | (c-1) | (d-8) | (e) |
| (a-1) | (b) | (c-1) | (d-9) | (e) |
| (a-1) | (b) | (c-1) | (d-10) | (e) |
| (a-1) | (b) | (c-1) | (d-11) | (e) |
| (a-1) | (b) | (c-1) | (d-12) | (e) |
| (a-1) | (b) | (c-1) | (d-13) | (e) |
| (a-1) | (b) | (c-1) | (d-14) | (e) |
| (a-1) | (b) | (c-1) | (d-15) | (e) |
| (a-1) | (b) | (c-1) | (d-16) | (e) |
| (a-1) | (b) | (c-1) | (d-17) | (e) |
| (a-1) | (b) | (c-2) | (d-1) | (e) |
| (a-1) | (b) | (c-2) | (d-2) | (e) |
| (a-1) | (b) | (c-2) | (d-3) | (e) |
| (a-1) | (b) | (c-2) | (d-4) | (e) |
| (a-1) | (b) | (c-2) | (d-5) | (e) |
| (a-1) | (b) | (c-2) | (d-6) | (e) |
| (a-1) | (b) | (c-2) | (d-7) | (e) |
| (a-1) | (b) | (c-2) | (d-8) | (e) |
| (a-1) | (b) | (c-2) | (d-9) | (e) |
| (a-1) | (b) | (c-2) | (d-10) | (e) |
| (a-1) | (b) | (c-2) | (d-11) | (e) |
| (a-1) | (b) | (c-2) | (d-12) | (e) |
| (a-1) | (b) | (c-2) | (d-13) | (e) |
| (a-1) | (b) | (c-2) | (d-14) | (e) |
| (a-1) | (b) | (c-2) | (d-15) | (e) |
| (a-1) | (b) | (c-2) | (d-16) | (e) |
| (a-1) | (b) | (c-2) | (d-17) | (e) |
| (a-1) | (b) | (c-3) | (d-1) | (e) |
| (a-1) | (b) | (c-3) | (d-2) | (e) |
| (a-1) | (b) | (c-3) | (d-3) | (e) |
| (a-1) | (b) | (c-3) | (d-4) | (e) |
| (a-1) | (b) | (c-3) | (d-5) | (e) |
| (a-1) | (b) | (c-3) | (d-6) | (e) |
| (a-1) | (b) | (c-3) | (d-7) | (e) |
| (a-1) | (b) | (c-3) | (d-8) | (e) |
| (a-1) | (b) | (c-3) | (d-9) | (e) |
| (a-1) | (b) | (c-3) | (d-10) | (e) |
| (a-1) | (b) | (c-3) | (d-11) | (e) |
| (a-1) | (b) | (c-3) | (d-12) | (e) |
| (a-1) | (b) | (c-3) | (d-13) | (e) |
| (a-1) | (b) | (c-3) | (d-14) | (e) |
| (a-1) | (b) | (c-3) | (d-15) | (e) |
| (a-1) | (b) | (c-3) | (d-16) | (e) |
| (a-1) | (b) | (c-3) | (d-17) | (e) |
| (a-1) | (b) | (c-1) | (d-1)(d-2) | (e) |
| (a-1) | (b) | (c-1) | (d-1)(d-3) | (e) |
| (a-1) | (b) | (c-1) | (d-1)(d-4) | (e) |
| (a-1) | (b) | (c-1) | (d-1)(d-5) | (e) |
| (a-1) | (b) | (c-1) | (d-1)(d-6) | (e) |
| (a-1) | (b) | (c-1) | (d-1)(d-7) | (e) |
| (a-1) | (b) | (c-1) | (d-1)(d-8) | (e) |
| (a-1) | (b) | (c-1) | (d-1)(d-9) | (e) |
| (a-1) | (b) | (c-1) | (d-1)(d-10) | (e) |
| (a-1) | (b) | (c-1) | (d-1)(d-11) | (e) |
| (a-1) | (b) | (c-1) | (d-1)(d-12) | (e) |
| (a-1) | (b) | (c-1) | (d-1)(d-13) | (e) |
| (a-1) | (b) | (c-1) | (d-1)(d-14) | (e) |
| (a-1) | (b) | (c-1) | (d-1)(d-1 5) | (e) |
| (a-1) | (b) | (c-1) | (d-1)(d-16) | (e) |
| (a-1) | (b) | (c-1) | (d-1)(d-17) | (e) |
| (a-1) | (b) | (c-1) | (d-2)(d-1) | (e) |
| (a-1) | (b) | (c-1) | (d-2)(d-3) | (e) |
| (a-1) | (b) | (c-1) | (d-2)(d-4) | (e) |
| (a-1) | (b) | (c-1) | (d-2)(d-5) | (e) |
| (a-1) | (b) | (c-1) | (d-2)(d-6) | (e) |
| (a-1) | (b) | (c-1) | (d-2)(d-7) | (e) |
| (a-1) | (b) | (c-1) | (d-2)(d-8) | (e) |
| (a-1) | (b) | (c-1) | (d-2)(d-9) | (e) |
| (a-1) | (b) | (c-1) | (d-2)(d-10) | (e) |
| (a-1) | (b) | (c-1) | (d-2)(d-11) | (e) |
| (a-1) | (b) | (c-1) | (d-2)(d-12) | (e) |
| (a-1) | (b) | (c-1) | (d-2)(d-13) | (e) |
| (a-1) | (b) | (c-1) | (d-2)(d-14) | (e) |
| (a-1) | (b) | (c-1) | (d-2)(d-15) | (e) |
| (a-1) | (b) | (c-1) | (d-2)(d-16) | (e) |
| (a-1) | (b) | (c-1) | (d-2)(d-17) | (e) |
| (a-1) | (b) | (c-1) | (d-3)(d-1) | (e) |
| (a-1) | (b) | (c-1) | (d-3)(d-2) | (e) |
| (a-1) | (b) | (c-1) | (d-3)(d-4) | (e) |
| (a-1) | (b) | (c-1) | (d-3)(d-5) | (e) |
| (a-1) | (b) | (c-1) | (d-3)(d-6) | (e) |
| (a-1) | (b) | (c-1) | (d-3)(d-7) | (e) |
| (a-1) | (b) | (c-1) | (d-3)(d-8) | (e) |
| (a-1) | (b) | (c-1) | (d-3)(d-9) | (e) |
| (a-1) | (b) | (c-1) | (d-3)(d-10) | (e) |
| (a-1) | (b) | (c-1) | (d-3)(d-11) | (e) |
| (a-1) | (b) | (c-1) | (d-3)(d-12) | (e) |
| (a-1) | (b) | (c-1) | (d-3)(d-13) | (e) |
| (a-1) | (b) | (c-1) | (d-3)(d-14) | (e) |
| (a-1) | (b) | (c-1) | (d-3)(d-15) | (e) |
| (a-1) | (b) | (c-1) | (d-3)(d-16) | (e) |
| (a-1) | (b) | (c-1) | (d-3)(d-17) | (e) |
| (a-1) | (b) | (c-1) | (d-4)(d-1) | (e) |
| (a-1) | (b) | (c-1) | (d-4)(d-2) | (e) |
| (a-1) | (b) | (c-1) | (d-4)(d-3) | (e) |
| (a-1) | (b) | (c-1) | (d-4)(d-5) | (e) |
| (a-1) | (b) | (c-1) | (d-4)(d-6) | (e) |
| (a-1) | (b) | (c-1) | (d-4)(d-7) | (e) |
| (a-1) | (b) | (c-1) | (d-4)(d-8) | (e) |
| (a-1) | (b) | (c-1) | (d-4)(d-9) | (e) |
| (a-1) | (b) | (c-1) | (d-4)(d-10) | (e) |
| (a-1) | (b) | (c-1) | (d-4)(d-11) | (e) |
| (a-1) | (b) | (c-1) | (d-4)(d-12) | (e) |
| (a-1) | (b) | (c-1) | (d-4)(d-13) | (e) |
| (a-1) | (b) | (c-1) | (d-4)(d-14) | (e) |
| (a-1) | (b) | (c-1) | (d-4)(d-15) | (e) |
| (a-1) | (b) | (c-1) | (d-4)(d-16) | (e) |
| (a-1) | (b) | (c-1) | (d-4)(d-17) | (e) |
| (a-1) | (b) | (c-1) | (d-5)(d-1) | (e) |
| (a-1) | (b) | (c-1) | (d-5)(d-2) | (e) |
| (a-1) | (b) | (c-1) | (d-5)(d-3) | (e) |
| (a-1) | (b) | (c-1) | (d-5)(d-4) | (e) |
| (a-1) | (b) | (c-1) | (d-5)(d-6) | (e) |
| (a-1) | (b) | (c-1) | (d-5)(d-7) | (e) |
| (a-1) | (b) | (c-1) | (d-5)(d-8) | (e) |
| (a-1) | (b) | (c-1) | (d-5)(d-9) | (e) |
| (a-1) | (b) | (c-1) | (d-5)(d-10) | (e) |
| (a-1) | (b) | (c-1) | (d-5)(d-11) | (e) |
| (a-1) | (b) | (c-1) | (d-5)(d-12) | (e) |
| (a-1) | (b) | (c-1) | (d-5)(d-13) | (e) |
| (a-1) | (b) | (c-1) | (d-5)(d-14) | (e) |
| (a-1) | (b) | (c-1) | (d-5)(d-15) | (e) |
| (a-1) | (b) | (c-1) | (d-5)(d-16) | (e) |
| (a-1) | (b) | (c-1) | (d-5)(d-17) | (e) |
| (a-1) | (b) | (c-1) | (d-6)(d-1) | (e) |
| (a-1) | (b) | (c-1) | (d-6)(d-2) | (e) |
| (a-1) | (b) | (c-1) | (d-6)(d-3) | (e) |
| (a-1) | (b) | (c-1) | (d-6)(d-4) | (e) |
| (a-1) | (b) | (c-1) | (d-6)(d-5) | (e) |
| (a-1) | (b) | (c-1) | (d-6)(d-7) | (e) |
| (a-1) | (b) | (c-1) | (d-6)(d-8) | (e) |
| (a-1) | (b) | (c-1) | (d-6)(d-9) | (e) |
| (a-1) | (b) | (c-1) | (d-6)(d-10) | (e) |
| (a-1) | (b) | (c-1) | (d-6)(d-11) | (e) |
| (a-1) | (b) | (c-1) | (d-6)(d-12) | (e) |
| (a-1) | (b) | (c-1) | (d-6)(d-13) | (e) |
| (a-1) | (b) | (c-1) | (d-6)(d-14) | (e) |
| (a-1) | (b) | (c-1) | (d-6)(d-15) | (e) |
| (a-1) | (b) | (c-1) | (d-6)(d-16) | (e) |
| (a-1) | (b) | (c-1) | (d-6)(d-17) | (e) |
| (a-1) | (b) | (c-1) | (d-7)(d-1) | (e) |
| (a-1) | (b) | (c-1) | (d-7)(d-2) | (e) |
| (a-1) | (b) | (c-1) | (d-7)(d-3) | (e) |
| (a-1) | (b) | (c-1) | (d-7)(d-4) | (e) |
| (a-1) | (b) | (c-1) | (d-7)(d-5) | (e) |
| (a-1) | (b) | (c-1) | (d-7)(d-6) | (e) |
| (a-1) | (b) | (c-1) | (d-7)(d-B) | (e) |
| (a-1) | (b) | (c-1) | (d-7)(d-9) | (e) |
| (a-1) | (b) | (c-1) | (d-7)(d-10) | (e) |
| (a-1) | (b) | (c-1) | (d-7)(d-11) | (e) |
| (a-1) | (b) | (c-1) | (d-7)(d-12) | (e) |
| (a-1) | (b) | (c-1) | (d-7)(d-13) | (e) |
| (a-1) | (b) | (c-1) | (d-7)(d-14) | (e) |
| (a-1) | (b) | (c-1) | (d-7)(d-15) | (e) |
| (a-1) | (b) | (c-1) | (d-7)(d-16) | (e) |
| (a-1) | (b) | (c-1) | (d-7)(d-17) | (e) |
| (a-1) | (b) | (c-1) | (d-8)(d-1) | (e) |
| (a-1) | (b) | (c-1) | (d-8)(d-2) | (e) |
| (a-1) | (b) | (c-1) | (d-8)(d-3) | (e) |
| (a-1) | (b) | (c-1) | (d-8)(d-4) | (e) |
| (a-1) | (b) | (c-1) | (d-8)(d-5) | (e) |
| (a-1) | (b) | (c-1) | (d-8)(d-6) | (e) |
| (a-1) | (b) | (c-1) | (d-8)(d-7) | (e) |
| (a-1) | (b) | (c-1) | (d-8)(d-9) | (e) |
| (a-1) | (b) | (c-1) | (d-8)(d-10) | (e) |
| (a-1) | (b) | (c-1) | (d-8)(d-11) | (e) |
| (a-1) | (b) | (c-1) | (d-8)(d-12) | (e) |
| (a-1) | (b) | (c-1) | (d-8)(d-13) | (e) |
| (a-1) | (b) | (c-1) | (d-8)(d-14) | (e) |
| (a-1) | (b) | (c-1) | (d-8)(d-15) | (e) |
| (a-1) | (b) | (c-1) | (d-8)(d-16) | (e) |
| (a-1) | (b) | (c-1) | (d-8)(d-17) | (e) |
| (a-1) | (b) | (c-1) | (d-9)(d-1) | (e) |
| (a-1) | (b) | (c-1) | (d-9)(d-2) | (e) |
| (a-1) | (b) | (c-1) | (d-9)(d-3) | (e) |
| (a-1) | (b) | (c-1) | (d-9)(d-4) | (e) |
| (a-1) | (b) | (c-1) | (d-9)(d-5) | (e) |
| (a-1) | (b) | (c-1) | (d-9)(d-6) | (e) |
| (a-1) | (b) | (c-1) | (d-9)(d-7) | (e) |
| (a-1) | (b) | (c-1) | (d-9)(d-8) | (e) |
| (a-1) | (b) | (c-1) | (d-9)(d-10) | (e) |
| (a-1) | (b) | (c-1) | (d-9)(d-11) | (e) |
| (a-1) | (b) | (c-1) | (d-9)(d-12) | (e) |
| (a-1) | (b) | (c-1) | (d-9)(d-13) | (e) |
| (a-1) | (b) | (c-1) | (d-9)(d-14) | (e) |
| (a-1) | (b) | (c-1) | (d-9)(d-15) | (e) |
| (a-1) | (b) | (c-1) | (d-9)(d-16) | (e) |
| (a-1) | (b) | (c-1) | (d-9)(d-17) | (e) |
| (a-1) | (b) | (c-1) | (d-10)(d-1) | (e) |
| (a-1) | (b) | (c-1) | (d-10)(d-2) | (e) |
| (a-1) | (b) | (c-1) | (d-10)(d-3) | (e) |
| (a-1) | (b) | (c-1) | (d-10)(d-4) | (e) |
| (a-1) | (b) | (c-1) | (d-10)(d-5) | (e) |
| (a-1) | (b) | (c-1) | (d-10)(d-6) | (e) |
| (a-1) | (b) | (c-1) | (d-10)(d-7) | (e) |
| (a-1) | (b) | (c-1) | (d-1 0)(d-8) | (e) |
| (a-1) | (b) | (c-1) | (d-10)(d-9) | (e) |
| (a-1) | (b) | (c-1) | (d-10)(d-11) | (e) |
| (a-1) | (b) | (c-1) | (d-10)(d-12) | (e) |
| (a-1) | (b) | (c-1) | (d-1 0)(d-13) | (e) |
| (a-1) | (b) | (c-1) | (d-10)(d-14) | (e) |
| (a-1) | (b) | (c-1) | (d-1 0)(d-15) | (e) |
| (a-1) | (b) | (c-1) | (d-10)(d-16) | (e) |
| (a-1) | (b) | (c-1) | (d-10)(d-17) | (e) |
| (a-1) | (b) | (c-1) | (d-11)(d-1) | (e) |
| (a-1) | (b) | (c-1) | (d-11)(d-2) | (e) |
| (a-1) | (b) | (c-1) | (d-11)(d-3) | (e) |
| (a-1) | (b) | (c-1) | (d-11)(d-4) | (e) |
| (a-1) | (b) | (c-1) | (d-11)(d-5) | (e) |
| (a-1) | (b) | (c-1) | (d-11)(d-6) | (e) |
| (a-1) | (b) | (c-1) | (d-11)(d-7) | (e) |
| (a-1) | (b) | (c-1) | (d-11)(d-8) | (e) |
| (a-1) | (b) | (c-1) | (d-11)(d-9) | (e) |
| (a-1) | (b) | (c-1) | (d-11)(d-10) | (e) |
| (a-1) | (b) | (c-1) | (d-11)(d-12) | (e) |
| (a-1) | (b) | (c-1) | (d-11)(d-13) | (e) |
| (a-1) | (b) | (c-1) | (d-11)(d-14) | (e) |
| (a-1) | (b) | (c-1) | (d-11)(d-15) | (e) |
| (a-1) | (b) | (c-1) | (d-11)(d-16) | (e) |
| (a-1) | (b) | (c-1) | (d-11)(d-17) | (e) |
| (a-1) | (b) | (c-1) | (d-12)(d-1) | (e) |
| (a-1) | (b) | (c-1) | (d-12)(d-2) | (e) |
| (a-1) | (b) | (c-1) | (d-12)(d-3) | (e) |
| (a-1) | (b) | (c-1) | (d-12)(d-4) | (e) |
| (a-1) | (b) | (c-1) | (d-12)(d-5) | (e) |
| (a-1) | (b) | (c-1) | (d-12)(d-6) | (e) |
| (a-1) | (b) | (c-1) | (d-12)(d-7) | (e) |
| (a-1) | (b) | (c-1) | (d-12)(d-8) | (e) |
| (a-1) | (b) | (c-1) | (d-12)(d-9) | (e) |
| (a-1) | (b) | (c-1) | (d-12)(d-10) | (e) |
| (a-1) | (b) | (c-1) | (d-12)(d-11) | (e) |
| (a-1) | (b) | (c-1) | (d-12)(d-13) | (e) |
| (a-1) | (b) | (c-1) | (d-12)(d-14) | (e) |
| (a-1) | (b) | (c-1) | (d-12)(d-15) | (e) |
| (a-1) | (b) | (c-1) | (d-12)(d-16) | (e) |
| (a-1) | (b) | (c-1) | (d-12)(d-17) | (e) |
| (a-1) | (b) | (c-1) | (d-13)(d-1) | (e) |
| (a-1) | (b) | (c-1) | (d-13)(d-2) | (e) |
| (a-1) | (b) | (c-1) | (d-13)(d-3) | (e) |
| (a-1) | (b) | (c-1) | (d-13)(d-4) | (e) |
| (a-1) | (b) | (c-1) | (d-13)(d-5) | (e) |
| (a-1) | (b) | (c-1) | (d-13)(d-6) | (e) |
| (a-1) | (b) | (c-1) | (d-13)(d-7) | (e) |
| (a-1) | (b) | (c-1) | (d-13)(d-8) | (e) |
| (a-1) | (b) | (c-1) | (d-13)(d-9) | (e) |
| (a-1) | (b) | (c-1) | (d-13)(d-10) | (e) |
| (a-1) | (b) | (c-1) | (d-13)(d-11) | (e) |
| (a-1) | (b) | (c-1) | (d-1 3)(d-12) | (e) |
| (a-1) | (b) | (c-1) | (d-13)(d-14) | (e) |
| (a-1) | (b) | (c-1) | (d-13)(d-15) | (e) |
| (a-1) | (b) | (c-1) | (d-13)(d-16) | (e) |
| (a-1) | (b) | (c-1) | (d-13)(d-17) | (e) |
| (a-1) | (b) | (c-1) | (d-14)(d-1) | (e) |
| (a-1) | (b) | (c-1) | (d-14)(d-2) | (e) |
| (a-1) | (b) | (c-1) | (d-14)(d-3) | (e) |
| (a-1) | (b) | (c-1) | (d-14)(d-4) | (e) |
| (a-1) | (b) | (c-1) | (d-1 4)(d-5) | (e) |
| (a-1) | (b) | (c-1) | (d-14)(d-6) | (e) |
| (a-1) | (b) | (c-1) | (d-14)(d-7) | (e) |
| (a-1) | (b) | (c-1) | (d-14)(d-8) | (e) |
| (a-1) | (b) | (c-1) | (d-14)(d-9) | (e) |
| (a-1) | (b) | (c-1) | (d-14)(d-10) | (e) |
| (a-1) | (b) | (c-1) | (d-14)(d-11) | (e) |
| (a-1) | (b) | (c-1) | (d-14)(d-12) | (e) |
| (a-1) | (b) | (c-1) | (d-14)(d-13) | (e) |
| (a-1) | (b) | (c-1) | (d-14)(d-15) | (e) |
| (a-1) | (b) | (c-1) | (d-14)(d-16) | (e) |
| (a-1) | (b) | (c-1) | (d-14)(d-17) | (e) |
| (a-1) | (b) | (c-1) | (d-1 5)(d-1) | (e) |
| (a-1) | (b) | (c-1) | (d-15)(d-2) | (e) |
| (a-1) | (b) | (c-1) | (d-15)(d-3) | (e) |
| (a-1) | (b) | (c-1) | (d-1 5)(d-4) | (e) |
| (a-1) | (b) | (c-1) | (d-15)(d-5) | (e) |
| (a-1) | (b) | (c-1) | (d-15)(d-6) | (e) |
| (a-1) | (b) | (c-1) | (d-1 5)(d-7) | (e) |
| (a-1) | (b) | (c-1) | (d-15)(d-8) | (e) |
| (a-1) | (b) | (c-1) | (d-15)(d-9) | (e) |
| (a-1) | (b) | (c-1) | (d-15)(d-10) | (e) |
| (a-1) | (b) | (c-1) | (d-1 5)(d-11) | (e) |
| (a-1) | (b) | (c-1) | (d-1 5)(d-12) | (e) |
| (a-1) | (b) | (c-1) | (d-15)(d-13) | (e) |
| (a-1) | (b) | (c-1) | (d-15)(d-14) | (e) |
| (a-1) | (b) | (c-1) | (d-1 5)(d-16) | (e) |
| (a-1) | (b) | (c-1) | (d-1 5)(d-17) | (e) |
| (a-1) | (b) | (c-1) | (d-16)(d-1) | (e) |
| (a-1) | (b) | (c-1) | (d-1 6)(d-2) | (e) |
| (a-1) | (b) | (c-1) | (d-1 6)(d-3) | (e) |
| (a-1) | (b) | (c-1) | (d-16)(d-4) | (e) |
| (a-1) | (b) | (c-1) | (d-16)(d-5) | (e) |
| (a-1) | (b) | (c-1) | (d-16)(d-6) | (e) |
| (a-1) | (b) | (c-1) | (d-1 6)(d-7) | (e) |
| (a-1) | (b) | (c-1) | (d-16)(d-8) | (e) |
| (a-1) | (b) | (c-1) | (d-16)(d-9) | (e) |
| (a-1) | (b) | (c-1) | (d-16)(d-10) | (e) |
| (a-1) | (b) | (c-1) | (d-16)(d-11) | (e) |
| (a-1) | (b) | (c-1) | (d-16)(d-12) | (e) |
| (a-1) | (b) | (c-1) | (d-1 6)(d-13) | (e) |
| (a-1) | (b) | (c-1) | (d-16)(d-14) | (e) |
| (a-1) | (b) | (c-1) | (d-16)(d-15) | (e) |
| (a-1) | (b) | (c-1) | (d-16)(d-17) | (e) |
| (a-1) | (b) | (c-1) | (d-17)(d-1) | (e) |
| (a-1) | (b) | (c-1) | (d-17)(d-2) | (e) |
| (a-1) | (b) | (c-1) | (d-17)(d-3) | (e) |
| (a-1) | (b) | (c-1) | (d-17)(d-4) | (e) |
| (a-1) | (b) | (c-1) | (d-17)(d-5) | (e) |
| (a-1) | (b) | (c-1) | (d-17)(d-6) | (e) |
| (a-1) | (b) | (c-1) | (d-17)(d-7) | (e) |
| (a-1) | (b) | (c-1) | (d-17)(d-8) | (e) |
| (a-1) | (b) | (c-1) | (d-17)(d-9) | (e) |
| (a-1) | (b) | (c-1) | (d-17)(d-10) | (e) |
| (a-1) | (b) | (c-1) | (d-17)(d-11) | (e) |
| (a-1) | (b) | (c-1) | (d-17)(d-12) | (e) |
| (a-1) | (b) | (c-1) | (d-17)(d-13) | (e) |
| (a-1) | (b) | (c-1) | (d-17)(d-14) | (e) |
| (a-1) | (b) | (c-1) | (d-17)(d-15) | (e) |
| (a-1) | (b) | (c-1) | (d-17)(d-16) | (e) |

The formulation has pH of 1 to 5, preferably 2 to 4.

Treatment temperature of the formulation is not specifically limited while it could remove residue completely. For example, the treatment temperature of 21-40°C affords sufficient effect.

Treatment time of the formulation is not specifically limited while it could remove residue completely. For example, the treatment time of 1-5 min affords sufficient effect.

Treatment procedure of the formulation is not specifically limited while it contact to the wafer containing residues. The formulation can be suitably applied to batch process or single wafer process.

In addition, the formulation can be used for residue removal of wafers in semiconductor fabrication, for example it is useful for (1) a cleaning process after making via hole, (2) a cleaning process after making trench, (3) a cleaning process after punching of etch stopper layer, or (4) a cleaning process after CMP (chemical mechanical polishing).

### EXAMPLES

The present invention is explained with some examples described below, but this invention is not limited to these examples.

### (1) Copper oxide removal test

Copper blanket wafers were treated with 02 plasma (250°C, 120 sec) and the resulting copper oxide wafers were used for test. Each wafer was immersed into any one of formulations of Examples 1-15 and Comparative Examples 1-6 at 40°C for 2 min. After that each wafer was rinsed with deionized water and air-dried. Copper oxide removal ability was determined with optical microscopic observation and a qualitative analysis of oxidization state of copper on wafer surface measured with X-ray photoelectron spectroscopy (XPS; Shimadzu ESCA-3200).

The components of Examples 1-15 and Comparative Example 1-6, and the test results are shown in Tables 1-3. And copper oxide removal ability were estimated as follows:
○: Yellow colored surface of wafer (from optical microscopic observation), no Cu²⁺ peaks in XPS spectra.
× : Red colored surface of wafer (from optical microscopic observation), remain of Cu²⁺ peaks in XPS spectra.

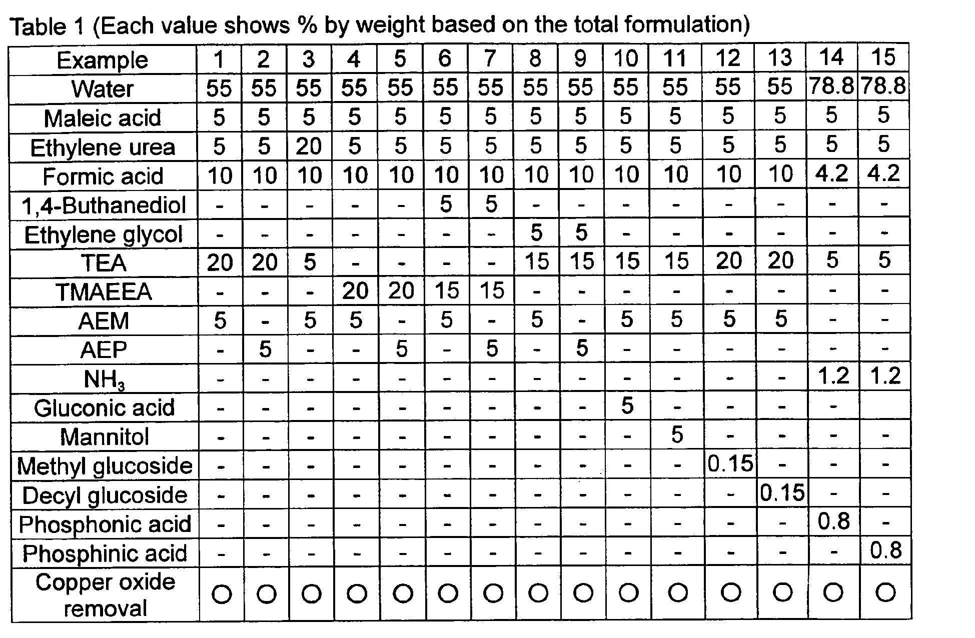

**Table 2 (Each value shows % by weight based on the total formulation)**

| Comparative Example | 1 | 2 | 3 | 4 |
|---|---|---|---|---|
| Water | 55 | 55 | 55 | 55 |
| Maleic acid | - | - | 5 | 10 |
| Malonic acid | 5 | - | - | - |
| Acrylic acid | - | 5 | - | - |
| Ethylene urea | 5 | 5 | - | 5 |
| Formic acid | 10 | 10 - | | 5 |
| TEA | 20 | 20 | 20 | 20 |
| AEM | 5 | 5 | 15 | 5 |
| Copper oxide removal | × | × | × | × |

**Table 3 (Each value shows % by weight based on the total formulation)**

| Comparative Example | 5 | 6 |
|---|---|---|
| Water | 29 | - |
| NH₄F | 1 | - |
| Dimethylacetamide | 60 | - |
| Diethylene glycolmonomethylether | 10 | - |
| Monoethanolamine | - | 30 |
| Dimethylsulfoxide | - | 70 |
| Copper oxide removal | × | × |

### (2) Removal test for punching residue of low-k and ultra low-k interlayer insulator layer and etch stopper layer

Wafers for cleaning evaluation of dual damascene or single damascene structure having punching residue of etch stopper layer were used for evaluation of the formulation of the present invention. The wafers were immersed into any one of the formulations at 40°C for 5 min. After each wafer was rinsed with deionized water and air-dried, removal ability of punching residue of the etch stopper layer and corrosivity of copper, or low-k or ultra low-k interlayer insulator layer were determined with scanning electron microscopic (SEM) observation.

Preferable formulations of the present invention could completely remove punching residue of etch stopper layer without any damage on copper, or low-k or ultra low-k interlayer insulator layer. Further, etching residue of low-k or ultra low-k interlayer insulator layer could also be completely removed. The preferable formulations indicate the most excellent results, and have comparable performance each other when they are evaluated based on both removable ability and low corrosivity as a whole.

While the present invention has been described with reference to certain preferred embodiments, it will be understood by those skilled in the art that various alternations and modifications may be made therein without departing from the true spirit and scope of the invention. It is therefore intended that the following claims cover all such alternations and modifications, which nevertheless include the true spirit and scope of the invention.

## Claims

1. A semiconductor wafer cleaning formulation for use in semiconductor fabrication comprising an unsaturated dicarboxylic acid, and ethylene urea.

2. The cleaning formulation according to claim 1, wherein the formulation is an aqueous solution.

3. The cleaning formulation according to claim 2, comprising
1-9% by weight of an unsaturated dicarboxylic acid; and
1-20% by weight of ethylene urea.

4. The cleaning formulation according to claim 2, further comprising
at least one organic carboxylic acid except unsaturated dicarboxylic acid, and
at least one basic compound except ethylene urea.

5. The cleaning formulation according to claim 4, comprising
1-9% by weight of an unsaturated dicarboxylic acid;
1-20% by weight of ethylene urea;
1-20% by weight of at least one organic carboxylic acid except unsaturated dicarboxylic acid;
0.1-50% by weight of at least one basic compound except ethylene urea; and
20-90% by weight of water.

6. The cleaning formulation according to claim 4, wherein the unsaturated dicarboxylic acid is selected from the group consisting of maleic acid and citraconic acid.

7. The cleaning formulation according to claim 4, wherein the unsaturated dicarboxylic acid is maleic acid.

8. The cleaning formulation according to claim 4, wherein the organic carboxylic acid is selected from the group consisting of:
formic acid (FA),
acetic acid (AA), and
propionic acid (PA).

9. The cleaning formulation according to claim 4, wherein the basic compound is selected from the group consisting of:
hydroxyethylpiperazine (HEP),
hydroxypropylpiperazine (HPP),
aminoethylpiperazine (AEP),
aminopropylpiperazine (APP),
hydroxyethylmorpholine (HEM),
hydroxypropylmorpholine (HPM),
aminoethylmorpholine (AEM),
aminopropylmorpholine (APM),
triethanolamine (TEA),
pentamethyldiethylenetriamine (PMDETA),
dimethylaminoethoxyethanol (DMAEE),
aminoethoxyethanol (AEE),
trimethylaminoethylethanolamine (TMAEEA),
trimethylaminopropylethanolamine (TMAPEA),
N-(2-cyanoethyl)ethylenediamine (CEEDA),
N-(2-cyanopropyl)ethylenediamine (CPEDA), and
ammonia (NH₃).

10. The cleaning formulation according to claim 4, further comprising at least one selected from the group consisting of:
an organic solvent,
a chelating agent,
a surfactant, and
phosphonic acid and/or phosphinic acid.

11. The cleaning formulation according to claim 10, wherein 1-20% by weight of the organic solvent, 0.01-5% by weight of the chelating agent, 0.01-0.2% by weight of the surfactant, and 0.5-5% by weight of phosphonic acid and/or phosphinic acid are contained.

12. The cleaning formulation according to claim 10, wherein the organic solvent is selected from the group consisting of:
1,4-butanediol (1,4-BD),
1,3-butanediol (1,3-BD),
ethylene glycol (EG),
propylene glycol (PG),
N-methylpyrrolidone(NMP),
γ-butyrolactone (GBL),
propylene glycol monomethylether (PGME), and
propylene glycol monomethylether acetate (PGMEA).

13. The cleaning formulation according to claim 10, wherein the chelating agent is selected from the group consisting of:
ascorbic acid,
gluconic acid,
mannitol,
sorbitol, and
boric acid.

14. The cleaning formulation according to claim 10, wherein the surfactant is a C₁₋₁₀alkyl glucoside.

15. A method for cleaning a semiconductor wafer comprising:
cleaning the wafer by using a chemical formulation comprising an unsaturated dicarboxylic acid, and ethylene urea in semiconductor fabrication.

16. The method according to claim 15, wherein the formulation is an aqueous solution.

17. The method according to claim 16, wherein the formulation comprises
1-9% by weight of an unsaturated dicarboxylic acid; and
1-20% by weight of ethylene urea.

18. The method according to claim 16, wherein the formulation further comprises:
at least one organic carboxylic acid except unsaturated dicarboxylic acid, and
at least one basic compound except ethylene urea.

19. The method according to claim 18, wherein the formulation comprises:
1-9% by weight of an unsaturated dicarboxylic acid;
1-20% by weight of ethylene urea;
1-20% by weight of at least one organic carboxylic acid except unsaturated dicarboxylic acid;
0.1-50% by weight of at least one basic compound except ethylene urea; and
20-90% by weight of water.

20. The method according to claim 18, wherein the unsaturated dicarboxylic acid is selected from the group consisting of maleic acid and citraconic acid.

21. The method according to claim 18, wherein the unsaturated dicarboxylic acid is maleic acid.

22. The method according to claim 18, wherein the organic carboxylic acid is selected from the group consisting of:
formic acid (FA),
acetic acid (AA), and
propionic acid (PA).

23. The method according to claim 18, wherein the basic compound is selected from the group consisting of:
hydroxyethylpiperazine (HEP),
hydroxypropylpiperazine (HPP),
aminoethylpiperazine (AEP),
aminopropylpiperazine (APP),
hydroxyethylmorpholine (HEM),
hydroxypropylmorpholine (HPM),
aminoethylmorpholine (AEM),
aminopropylmorpholine (APM),
triethanolamine (TEA),
pentamethyldiethylenetriamine (PMDETA),
dimethylaminoethoxyethanol (DMAEE),
aminoethoxyethanol (AEE),
trimethylaminoethylethanolamine (TMAEEA),
trimethylaminopropylethanolamine (TMAPEA),
N-(2-cyanoethyl)ethylenediamine (CEEDA),
N-(2-cyanopropyl)ethylenediamine (CPEDA), and
ammonia (NH₃).

24. The method according to claim 18, wherein the formulation further comprises at least one selected from the group consisting of:
an organic solvent,
a chelating agent,
a surfactant, and
phosphonic acid and/or phosphinic acid.

25. The method according to claim 24, wherein 1-20% by weight of the organic solvent, 0.01-5% by weight of the chelating agent, 0.01-0.2% by weight of the surfactant, and 0.5-5% by weight of phosphonic acid and/or phosphinic acid are contained.

26. The method according to claim 24, wherein the organic solvent is selected from the group consisting of:
1,4-butanediol (1,4-BD),
1,3-butanediol (1,3-BD),
ethylene glycol (EG),
propylene glycol (PG),
N-methylpyrrolidone(NMP),
γ-butyrolactone (GBL),
propylene glycol monomethylether (PGME), and
propylene glycol monomethylether acetate (PGMEA).

27. The method according to claim 24, wherein the chelating agent is selected from the group consisting of:
ascorbic acid,
gluconic acid,
mannitol,
sorbitol, and
boric acid.

28. The method according to claim 24, wherein the surfactant is a C₁₋₁₀alkyl glucoside.

29. A method for cleaning a semiconductor wafer comprising:
cleaning the wafer by using a chemical formulation comprising an unsaturated dicarboxylic acid, and ethylene urea, in a cleaning process after a following process:
(i) making via hole;
(ii) making trench;
(iii) punching of etch stopper layer; or
(iv) CMP (chemical mechanical polishing) process.

30. The method according to claim 29, wherein the formulation is an aqueous solution.

31. The method according to claim 30, wherein the formulation comprises
1-9% by weight of an unsaturated dicarboxylic acid; and
1-20% by weight of ethylene urea.

32. The method according to claim 30, wherein the formulation further comprises:
at least one organic carboxylic acid except unsaturated dicarboxylic acid, and
at least one basic compound except ethylene urea.

33. The method according to claim 32, wherein the formulation comprises:
1-9% by weight of an unsaturated dicarboxylic acid;
1-20% by weight of ethylene urea;
1-20% by weight of at least one organic carboxylic acid except unsaturated dicarboxylic acid;
0.1-50% by weight of at least one basic compound except ethylene urea; and
20-90% by weight of water.

34. The method according to claim 32, wherein the unsaturated dicarboxylic acid is selected from the group consisting of maleic acid and citraconic acid.

35. The method according to claim 32, wherein the unsaturated dicarboxylic acid is maleic acid.

36. The method according to claim 32, wherein the organic carboxylic acid is selected from the group consisting of:
formic acid (FA),
acetic acid (AA), and
propionic acid (PA).

37. The method according to claim 32, wherein the basic compound is selected from the group consisting of:
hydroxyethylpiperazine (HEP),
hydroxypropylpiperazine (HPP),
aminoethylpiperazine (AEP),
aminopropylpiperazine (APP),
hydroxyethylmorpholine (HEM),
hydroxypropylmorpholine (HPM),
aminoethylmorpholine (AEM),
aminopropylmorpholine (APM),
triethanolamine (TEA),
pentamethyidiethylenetriamine (PMDETA),
dimethylaminoethoxyethanol (DMAEE),
aminoethoxyethanol (AEE),
trimethylaminoethylethanolamine (TMAEEA),
trimethylaminopropylethanolamine (TMAPEA),
N-(2-cyanoethyl)ethylenediamine (CEEDA),
N-(2-cyanopropyl)ethylenediamine (CPEDA), and
ammonia (NH₃).

38. The method according to claim 32, wherein the formulation further comprises at least one selected from the group consisting of:
an organic solvent,
a chelating agent,
a surfactant, and
phosphonic acid and/or phosphinic acid.

39. The method according to claim 38, wherein 1-20% by weight of the organic solvent, 0.01-5% by weight of the chelating agent, 0.01-0.2% by weight of the surfactant, and 0.5-5% by weight of phosphonic acid and/or phosphinic acid are contained.

40. The method according to claim 38, wherein the organic solvent is selected from the group consisting of:
1,4-butanediol (1,4-BD),
1,3-butanediol (1,3-BD),
ethylene glycol (EG),
propylene glycol (PG),
N-methylpyrrolidone(NMP),
γ-butyrolactone (GBL),
propylene glycol monomethylether (PGME), and
propylene glycol monomethylether acetate (PGMEA).

41. The method according to claim 38, wherein the chelating agent is selected from the group consisting of:
ascorbic acid,
gluconic acid,
mannitol,
sorbitol, and
boric acid.

42. The method according to claim 38, wherein the surfactant is a C₁₋₁₀alkyl glucoside.
